# EUROPÄISCHE PATENTSCHRIFT

(11) **EP 2 059 842 B1**
(45) Veröffentlichungstag und Bekanntmachung des Hinweises auf die Patenterteilung: **11.11.2015**
(21) Anmeldenummer: 07856158.6
(22) Anmeldetag: 21.12.2007
(51) Int. Cl.: G02B 7/02, H01L 33/00

(54) **LINSENANORDNUNG UND LED-ANZEIGEVORRICHTUNG**
LENS ARRANGEMENT UND LED DISPLAY DEVICE
ENSEMBLE LENTILLE ET DISPOSITIF D'AFFICHAGE À DIODE LUMINEUSE

(30) Priorität: 29.12.2006 DE 102006062066
(43) Veröffentlichungstag der Anmeldung: 20.05.2009
(73) Patentinhaber: OSRAM Opto Semiconductors GmbH, 93055 Regensburg (DE)
(72) Erfinder: GRÖTSCH, Stefan, 93077 Lengfeld-Bad Abbach (DE); ENGL, Moritz, 93055 Regensburg (DE); KÖHLER, Steffen, 93049 Regensburg (DE); BLÜMEL, Simon, 84069 Schierling (DE); HIEGLER, Michael, 73557 Mutlangen (DE); ZEILER, Thomas, 93152 Nittendorf (DE)
(74) Vertreter: Epping - Hermann - Fischer
(86) Internationale Anmeldenummer: PCT/DE2007/002321
(87) Internationale Veröffentlichungsnummer: WO 2008/080390

(56) Entgegenhaltungen:
- EP-A1- 1 691 425
- WO-A-2005/083804
- DE-A1- 10 261 974
- DE-A1-102005 036 520
- JP-A- 3 110 963
- JP-A- 2000 200 929
- US-A- 3 671 108
- US-A- 5 253 111
- US-A1- 2004 041 222
- US-A1- 2004 190 304
- US-A1- 2005 221 519
- US-B1- 6 188 841

## Beschreibung

Die Erfindung betrifft eine LED-Anzeigevorrichtung mit einer Linsenanordnung. Die Linsenanordnung umfasst eine Linse, die eine erste Linsenfläche und eine optische Achse aufweist. Die optische Achse durchdringt die erste Linsenfläche der Linse. Die LED-Anzeigevorrichtung hat ein Gehäuse, das eine Öffnung umfasst. Zumindest eine LED ist so in dem Gehäuse angeordnet, dass Strahlung, die in einer Hauptabstrahlrichtung der LED abgestrahlt wird, durch die Öffnung des Gehäuses austritt.

Als Lichtquellen werden immer häufiger LEDs bevorzugt. Die LEDs zeichnen sich durch eine hohe Lichtausbeute bei einem geringen Energiebedarf aus. Verglichen mit einer normalen Glühbirne erzeugen die LEDs bei vergleichbarer Lichtausbeute regelmäßig weit weniger Hitze. Dennoch können bei Betrieb der LED in der Nähe der LED sehr hohe Temperaturen auftreten.

Es ist Aufgabe der Erfindung, eine LED-Anzeigevorrichtung zu schaffen, die eine Ankopplung der Linsenanordnung an einen thermisch belasteten Bereich ermöglicht.

Die Aufgabe der Erfindung wird gelöst durch die Merkmale des unabhängigen Anspruchs 1. Vorteilhafte Ausgestaltungen der Erfindung sind in den Unteransprüchen angegeben.

Die Erfindung zeichnet sich aus durch eine LED-Anzeigevorrichtung mit einer Linsenanordnung, einem Gehäuse mit einer Öffnung und zumindest einer LED, die in dem Gehäuse so angeordnet ist, dass Strahlung, die in einer Hauptabstrahlrichtung der LED abgestrahlt wird, durch die Öffnung des Gehäuses austritt. Die Linsenanordnung umfasst eine Linse und einen transparenten Übergangskörper. Die Linse weist eine erste Linsenfläche und eine optische Achse auf. Die optische Achse der Linse durchdringt die erste Linsenfläche der Linse. Die Linsenanordnung ist so angeordnet, dass die von der LED in der Hauptabstrahlrichtung emittierte Strahlung den transparenten Übergangskörper und die Linse durchdringt. Der transparente Übergangskörper weist eine optische Achse auf, die parallel zu der optischen Achse der Linse ist. Die Linse umfasst ferner einen Kunststoff. Die Linse ist formbeständiger als der transparente Übergangskörper, der transparente Übergangskörper ist temperaturbeständiger als die Linse. Der transparente Übergangskörper ist an der ersten Linsenfläche fest mit der Linse gekoppelt, sitzt direkt auf der LED auf und ist zwischen der LED und der Linse angeordnet. Ferner umgibt der transparente Übergangskörper die Linse zumindest teilweise in radialer Richtung.

Falls die Linsenanordnung zum Kollimieren und/oder Fokussieren von Strahlung einer heißen Lichtquelle vorgesehen ist, ermöglicht dies, die Linsenanordnung nahe an der Lichtquelle anzuordnen, und zwar so, dass der transparente Übergangskörper zwischen der Linse und der Lichtquelle angeordnet ist. Ferner ermöglicht dies, bei einer Wahl eines Materials für die Linse vornehmlich optische Eigenschaften und/oder eine Formbarkeit und/oder eine Formfestigkeit des entsprechenden Materials zu berücksichtigen und weniger die thermischen Eigenschaften.

Der transparente Übergangskörper, der temperaturbeständiger ist als die Linse, schützt die Linse nicht nur vor thermischen Einflüssen, die durch die von der Lichtquelle abgestrahlte Strahlung entstehen, sondern kann die Linse gleichzeitig vor strahlungsbasierten Einflüssen schützen. Unter "strahlungsbasierten Einflüsse" sind im Folgenden die Einflüsse zu verstehen, die durch die Strahlungsdichte der von der Lichtquelle abgestrahlten Strahlung entstehen können. Durch den transparenten Übergangskörper kann die Linse vor strahlungsbasierten Einflüssen geschützt werden, da die Linse beabstandet von der Lichtquelle angeordnet ist. Somit wird die Linse vor der hohen Strahlungsdichte, die nahe an der Lichtquelle auftritt und die zur Zerstörung des Materials der Linse führen kann, geschützt. Durch den Abstand der Linse von der Lichtquelle, der dadurch entsteht, dass der transparente Übergangskörper zwischen der Linse und der Lichtquelle angeordnet ist, ist die Strahlungsdichte an der Linse verringert. Bei der Wahl eines Materials für die Linse ist daher die Strahlungsempfindlichkeit des entsprechenden Materials nur unwesentlich zu berücksichtigen. Dadurch können für hohe Strahlungsdichten empfindliche Materialien, wie beispielsweise Kunststoffmaterialien, für die Linse Verwendung finden.

In einer vorteilhaften Ausgestaltung der Erfindung entspricht die optische Achse der Linse der optischen Achse des transparenten Übergangskörpers. Die beiden optischen Achsen bilden eine optische Achse der Linsenanordnung. Dies trägt zu einer besonders präzisen Kollimierung und/oder Fokussierung von Strahlung durch die Linsenanordnung bei.

In einer weiteren vorteilhaften Ausgestaltung der Erfindung ist die Linse formbeständiger als der transparente Übergangskörper. Dies ermöglicht, die Form der Linse besonders präzise auszubilden und so eine besonders präzise Strahlführung und/oder Strahlformung durch die Linse zu erzielen. Ferner ermöglicht dies, eine besonders gute Ankopplung des transparenten Übergangskörpers an die Linse und an eine Strahlungsvorrichtung, beispielsweise die LED-Anzeigevorrichtung, die zumindest die Lichtquelle, beispielsweise die LED, umfasst. Erfindungsgemäß umgibt der Übergangskörper die Linse zumindest teilweise in radialer Richtung. Dies trägt dazu bei, die Linse noch besser gegen die Hitze der Lichtquelle abzuschirmen. Ferner kann dadurch eine besonders gute Kopplung zwischen der Linse und dem transparenten Übergangskörper erzielt werden.

In einer weiteren vorteilhaften Ausgestaltung der Erfindung weist die Linse zumindest eine Ausnehmung auf. Der Übergangskörper weist zumindest einen Haltekörper auf, der in die Ausnehmung der Linse ragt. Dies trägt zu einer besonders guten Kopplung zwischen der Linse und dem transparenten Übergangskörper bei. Ferner eröffnet sich dadurch ein zusätzlicher Gestaltungsspielraum bezüglich einer Strahlführung in der Linsenanordnung.

Die Erfindung zeichnet sich aus durch die LED-Anzeigevorrichtung. Die LED-Anzeigevorrichtung hat ein Gehäuse, zumindest die eine LED und zumindest die Linsenanordnung. Das Gehäuse umfasst eine Öffnung. Die LED ist so in dem Gehäuse angeordnet, dass Strahlung, die in einer Hauptabstrahlrichtung der LED abgestrahlt wird, durch die Öffnung des Gehäuses austritt. Die Linsenanordnung ist so angeordnet, dass die von der LED in der Hauptabstrahlrichtung emittierte Strahlung den transparenten Übergangskörper und die Linse durchdringt. Die Strahlung kann auch an einem Reflektor reflektiert werden, bevor sie aus dem Gehäuse austritt.

In einer Abwandlung der Erfindung hat der transparente Übergangskörper einen vorgegebenen positiven Abstand zu der LED. Dies kann dazu beitragen, dass eine Strahlungsdichte, der von der LED-Anzeigevorrichtung abgestrahlten Strahlung, höher ist und dass die Strahlung auf eine kleinere Fläche abgestrahlt wird gegenüber einer LED-Anzeigevorrichtung, bei der der Übergangskörper direkt mit der LED und/oder einer Vergussmasse gekoppelt ist, in der die LED eingebettet ist.

In einer weiteren vorteilhaften Ausgestaltung der Erfindung ist die LED zumindest teilweise von einer transparenten Vergussmasse ummantelt. Dies ermöglicht einfach, die LED zu schützen und zu befestigen. Ferner ermöglicht dies, falls die Vergussmasse zwischen dem transparenten Übergangskörper und der LED angeordnet ist, dass die Strahlung auf eine größere Fläche abgestrahlt wird, gegenüber einer LED-Anzeigevorrichtung, bei der zwischen Übergangskörper und LED keine Vergussmasse vorgesehen ist.

Die Erfindung ist im Folgenden anhand von schematischen Zeichnungen näher erläutert.

Es zeigen:
- Figur 1: eine erste Abwandlung einer LED-Anzeigevorrichtung,
- Figur 2: eine zweite Abwandlung der LED-Anzeigevorrichtung,
- Figur 3: eine dritte Abwandlung der LED-Anzeigevorrichtung,
- Figur 4: eine erste Ausführungsform einer Linsenanordnung,
- Figur 5: eine zweite Ausführungsform der Linsenanordnung.

Elemente gleicher Konstruktion oder Funktion sind figurenübergreifend mit den gleichen Bezugszeichen gekennzeichnet.

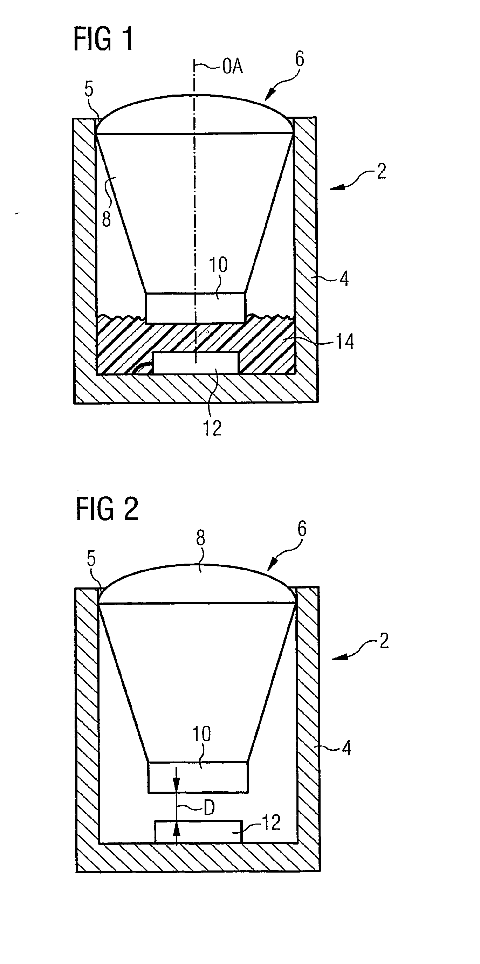

Eine LED-Anzeigevorrichtung 2 (Figur 1) umfasst ein Gehäuse 4 mit einer Öffnung 5. Ferner umfasst die LED-Anzeigevorrichtung 2 eine Linsenanordnung 6. Die Linsenanordnung 6 ist aus einer Linse 8 und einem transparenten Übergangskörper 10 gebildet. Ferner umfasst die LED-Anzeigevorrichtung eine LED 12.

Die LED 12 ist so in dem Gehäuse 4 angeordnet, dass Strahlung, die in einer Hauptabstrahlrichtung der LED abgestrahlt wird, das Gehäuse 4 durch die Öffnung 5 verlässt. Das bedeutet in diesem Zusammenhang, dass die Strahlung der LED direkt aus der Öffnung 5 des Gehäuses 4 abgestrahlt werden kann und/oder dass ein Reflektor in dem Gehäuse 4 angeordnet sein kann, der die Strahlung derart reflektiert, dass diese aus der Öffnung 5 des Gehäuses 4 abgestrahlt wird.

Die LED 12 umfasst vorzugsweise einen Halbleiterchip. Der Halbleiterchip ist steuerbar mit einem Stromkreis verbunden. Wird eine Spannung an die LED 12 angelegt, so strahlt diese Strahlung, vorzugsweise Licht im sichtbaren Bereich ab. Die LED 12 kann in einer Vergussmasse 14 eingebettet sein. Die Vergussmasse 14 kann beispielsweise Silikon und/oder Kunststoff umfassen. Die Vergussmasse 14 dient dazu, die LED 12 in ihrer Position zuhalten, die LED 12 zu schützen, die von der LED 12 abgestrahlte Strahlung zu beeinflussen und/oder den Winkelbereich der abgestrahlten Strahlung zu vergrößern.

Die Linsenanordnung 6 ist vorzugsweise so angeordnet, dass von der LED 12 abgestrahlte Strahlung die Linsenanordnung 6 durchdringen muss, bevor sie das Gehäuse 4 der LED-Anzeigevorrichtung 2 verlässt. Die Linse 8 hat eine optische Achse. Die optische Achse durchdringt eine erste Linsenfläche der Linse 8. Die erste Linsenfläche ist mit dem transparenten Übergangskörper 10 gekoppelt. Der transparente Übergangskörper 10 weist ebenfalls eine optische Achse auf. Die optischen Achsen der Linse 8 und des transparenten Übergangskörpers 10 können parallel zueinander sein. Vorzugsweise sind die Linse 8 und der transparente Übergangskörper 10 so miteinander gekoppelt, dass ihre optischen Achsen identisch sind und so eine optische Achse OA der Linsenanordnung 6 bilden.

Vorzugsweise sind die Linse 8 und der transparente Übergangskörper 10 fest miteinander gekoppelt, so dass durch die Linse 8 und den transparenten Übergangskörper 10 eine Zweikomponentenlinse gebildet ist. Die Zweikomponentenlinse kann auch als Linsenanordnung 6 bezeichnet werden. Die erste Fläche der Linse 8 und die Fläche des transparenten Übergangskörpers 10, die mit der ersten Fläche der Linse 8 gekoppelt ist, sind vorzugsweise so ausgebildet, dass die beiden Flächen möglichst ohne Lufteinschlüsse aneinander anliegen.

Die Linse 8 dient im Wesentlichen dazu, die Strahlführung der Linsenanordnung 6 zu beeinflussen. Daher umfasst die Linse 8 vorzugsweise ein formfestes Material. Das formfeste Material kann beispielsweise Glas, Kunststoff und/oder Silikon umfassen.

Der transparente Übergangskörper 10 ist vorzugsweise temperaturbeständiger als die Linse 8 ausgebildet. Daher umfasst der transparente Übergangskörper 10 vorzugsweise ein temperaturbeständiges Material. Das temperaturbeständige Material hält beispielsweise Temperaturen von 125°C und/oder mehr aus. An die Formbeständigkeit des transparenten Übergangskörpers 10 und an die Strahlungsempfindlichkeit des transparenten Übergangskörpers 10, also an die Eigenschaften, die die Beständigkeit bzgl. der Strahlungsdichte der von der Lichtquelle abgestrahlten Strahlung betreffen, sind jedoch geringere Anforderungen gestellt als an die Linse 8. Vorzugsweise ist der transparente Übergangskörper 10 formbarer als die Linse 8. Werden der transparente Übergangskörper 10 und die Linse 8 zusammengefügt, so kann dies dazu beitragen, dass die beiden Flächen der Linse 8 und des transparenten Übergangskörpers 10 ohne Lufteinflüsse aneinander anliegen.

Die LED-Anzeigevorrichtung 2 kann auch ohne die Vergussmasse 14 ausgebildet sein (Figur 2). Der transparente Übergangskörper 10 weist dann beispielsweise einen vorgegebenen positiven Abstand D von der LED 12 auf. Dies bewirkt, dass die von der LED 12 abgestrahlte Strahlung nach Durchdringen der Linsenanordnung 6 eine hohe Strahlungsdichte aufweist und auf eine relativ kleine Fläche abgestrahlt wird.

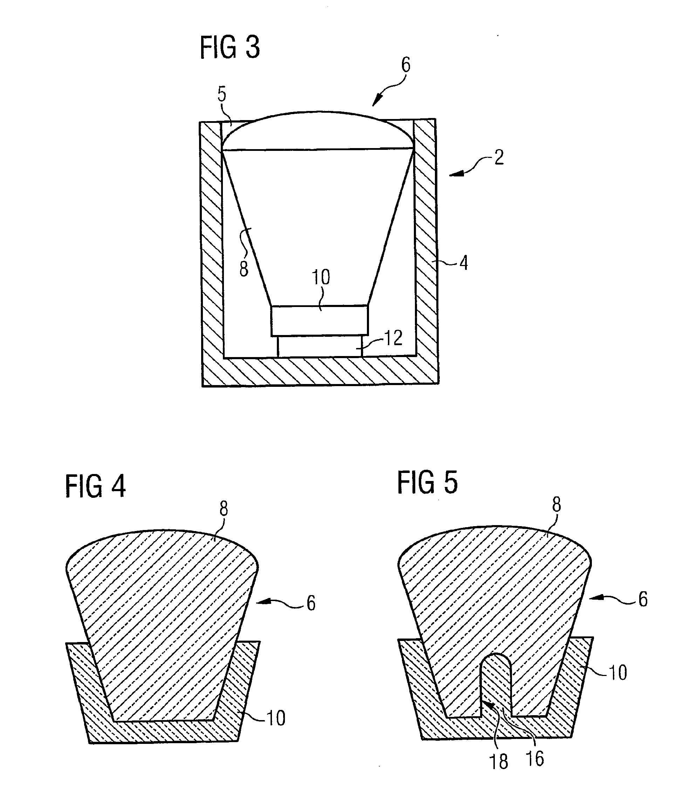

Alternativ dazu kann der transparente Übergangskörper auch direkt auf die LED 12 aufgesetzt werden (Figur 3). Dabei wird ein ähnlicher optischer Effekt wie durch die transparente Vergussmasse 14 erzielt. Ferner ermöglicht dies, falls der transparente Übergangskörper 10 formbar ausgebildet ist, einen Toleranzausgleich zwischen der Linsenanordnung 6 und dem Gehäuse 2. Ferner kann bei einer Belastung der Linsenanordnung 6 in Richtung parallel zu einem Boden des Gehäuses 4 und/oder Richtung senkrecht zu dem Boden des Gehäuses 4 der formbare transparente Übergangskörper 10 als Ausgleichskörper dienen. Dieser wird dann verformt und überträgt die Belastung nicht auf die LED 12.

Alternativ oder zusätzlich kann der transparente Übergangskörper 10 so ausgebildet sein, dass dieser die Linse 8 zumindest teilweise in radialer Richtung umgibt (Figur 4). Dies kann dazu beitragen, die Linse 8 zusätzlich vor thermischer Belastung abzuschirmen. Ferner kann dies dazu beitragen, eine besonders gute Kopplung zwischen der Linse 8 und dem transparenten Übergangskörper 10 zu erhalten.

Alternativ oder zusätzlich kann der transparente Übergangskörper 10 einen Haltekörper 16 aufweisen. Der Haltekörper 16 ragt dann vorzugsweise in eine Ausnehmung 18 der Linse 8. Dies kann die Kopplung zwischen der Linse 8 und dem transparenten Übergangskörper 10 weiter verbessern. Ferner kann dies zu einer erweiterten Strahlführung beitragen. Alternativ oder zusätzlich kann auch der transparente Übergangskörper 10 eine Ausnehmung aufweisen und die Linse 8 einen entsprechenden Haltekörper.

## Patentansprüche

1. LED-Anzeigevorrichtung (2) mit
- einem Gehäuse (4), das eine Öffnung (5) umfasst,
- zumindest einer LED (12), die in dem Gehäuse (4) so angeordnet ist, dass Strahlung, die in einer Hauptabstrahlrichtung der LED (12) abgestrahlt wird, durch die Öffnung (5) des Gehäuses (4) austritt,
- zumindest einer Linsenanordnung (6),
wobei
- die Linsenanordnung (6) eine Linse (8) umfasst, die eine erste Linsenfläche und eine optische Achse aufweist, die die erste Linsenfläche der Linse (8) durchdringt,
- die Linsenanordnung (6) einen transparenten Übergangskörper (10) umfasst,
- die Linsenanordnung (6) so angeordnet ist, dass die von der LED (12) in der Hauptabstrahlrichtung emittierte Strahlung den transparenten Übergangskörper (10) und die Linse (8) durchdringt,
- der transparente Übergangskörper (10) eine optische Achse aufweist, die parallel zu der optischen Achse der Linse (8) ist,
- die Linse (8) einen Kunststoff umfasst,
wobei
- die Linse (8) formbeständiger als der transparente Übergangskörper (10) ist,
- der transparente Übergangskörper (10) temperaturbeständiger als die Linse (8) ist,
- der transparente Übergangskörper (10) an der ersten Linsenfläche fest mit der Linse (8) gekoppelt ist,
- der transparente Übergangskörper (10) direkt auf der LED (12) aufsitzt,
- der transparente Übergangskörper (10) zwischen der LED (12) und der Linse (8) angeordnet ist,
**dadurch gekennzeichnet, dass**
- der transparente Übergangskörper (10) die Linse (8) zumindest teilweise in radialer Richtung umgibt.

2. LED-Anzeigevorrichtung (2) nach Anspruch 1, bei der die optische Achse der Linse (8) der optischen Achse des transparenten Übergangskörpers (10) entspricht und bei der die beiden optischen Achsen eine optische Achse (OA) der Linsenanordnung (6) bilden.

3. LED-Anzeigevorrichtung (2) nach einem der vorstehenden Ansprüche, bei der die Linse (8) zumindest eine Ausnehmung (18) aufweist und bei der der Übergangskörper (10) zumindest einen Haltkörper (16) aufweist, der in die Ausnehmung der Linse (8) ragt.

4. LED-Anzeigevorrichtung (2) nach Anspruch 1, bei der der Übergangskörper (10) geeignet ist, eine Strahlungsdichte der von der LED abgestrahlten Strahlung an der Linse (8) zu verringern.

5. LED-Anzeigevorrichtung (2) nach einem der vorstehenden Ansprüche, bei der die LED (12) zumindest teilweise von einer transparenten Vergussmasse (14) ummantelt ist.

## Claims

1. LED display device (2) comprising
- a housing (4), which comprises an opening (5),
- at least one LED (12) arranged in the housing (4) such that radiation emitted in a main emission direction of the LED (12) emerges through the opening (5) of the housing (4),
- at least one lens arrangement (6)
wherein
- the lens arrangement (6) comprises a lens (8) having a first lens surface and an optical axis penetrating through the first lens surface of the lens (8),
- the lens arrangement (6) comprises a transparent transition body (10),
- the lens arrangement (6) is arranged such that the radiation emitted by the LED (12) in the main emission direction penetrates through the transparent transition body (10) and the lens (8),
- the transparent transition body (10) has an optical axis parallel to the optical axis of the lens (8),
- the lens (8) comprises a plastic,
wherein
- the lens (8) is dimensionally stabler than the transparent transition body (10),
- the transparent transition body (10) is thermally stabler than the lens (8),
- the transparent transition body (10) is fixedly coupled to the lens (8) at the first lens surface,
- the transparent transition body (10) is seated directly on the LED (12),
- the transparent transition body (10) is arranged between the LED (12) and the lens (8), **characterized in that**
- the transparent transition body (10) surrounds the lens (8) at least partly in a radial direction.

2. LED display device (2) according to Claim 1, wherein the optical axis of the lens (8) corresponds to the optical axis of the transparent transition body (10), and wherein the two optical axes form an optical axis (OA) of the lens arrangement (6).

3. LED display device (2) according to either of the preceding claims, wherein the lens (8) has at least one cutout (18), and wherein the transition body (10) has at least one holding body (16) which projects into the cutout of the lens (8).

4. LED display device (2) according to Claim 1, wherein the transparent transition body (10) is suitable for reducing a radiance of the radiation emitted by the LED at the lens (8).

5. LED display device (2) according to any of the preceding claims, wherein the LED (12) is at least partly enveloped by a transparent potting compound (14).

## Revendications

1. Dispositif (2) d'affichage à LED présentant :
un boîtier (4) doté d'une ouverture (5),
au moins une LED (12) disposée dans le boîtier (4) de telle sorte que le rayonnement émis dans la direction principale de rayonnement de la LED (12) sorte du boîtier (4) par l'ouverture (5), au moins un ensemble de lentille (6), au cours de laquelle
l'ensemble de lentille (6) comprenant une lentille (8) qui présente une première surface et
un axe optique qui traverse la première surface de la lentille (8),
l'ensemble de lentille (6) comportant un corps transparent de transition (10),
l'ensemble de lentille (6) étant disposé de telle sorte que le rayonnement émis par la LED (12) dans la direction principale de rayonnement traverse le corps transparent de transition (10) et la lentille (8),
le corps transparent de transition (10) présentant un axe optique parallèle à l'axe optique de la lentille (8),
la lentille (8) comprenant une matière synthétique, au cours de laquelle la lentille (8) étant moins déformable que le corps transparent de transition (10),
le corps transparent de transition (10) étant plus résistant à la chaleur que la lentille (8),
le corps transparent de transition (10) étant solidarisé avec la lentille (8) sur la première surface de cette dernière,
le corps transparent de transition (10) reposant directement sur la LED (12),
le corps transparent de transition (10) étant disposé entre la LED (12) et la lentille (8),
**caractérisé en ce que**
le corps transparent de transition (10) entoure au moins partiellement la lentille (8) dans la direction radiale.

2. Dispositif (2) d'affichage à LED selon la revendication 1, dans lequel l'axe optique de la lentille (8) correspond à l'axe optique du corps transparent de transition (10) et dans lequel les deux axes optiques forment un axe optique (OA) de l'ensemble de lentille (6).

3. Dispositif (2) d'affichage à LED selon l'une des revendications précédentes, dans lequel la lentille (8) présente au moins une découpe (18) et dans lequel le corps de transition (10) présente au moins un corps de maintien (16) qui pénètre dans la découpe de la lentille (8).

4. Dispositif (2) d'affichage à LED selon la revendication 1, dans lequel le corps de transition (10) convient pour diminuer la densité du rayonnement émis par la LED sur la lentille (8).

5. Dispositif (2) d'affichage à LED selon l'une des revendications précédentes, dans lequel la LED (12) est englobée au moins en partie par une pâte transparente de moulage (14).
